# EUROPÄISCHE PATENTANMELDUNG

(11) **EP 0 578 172 A1**
(43) Veröffentlichungstag der Anmeldung: **12.01.1994**
(21) Anmeldenummer: 93110725.4
(22) Anmeldetag: 05.07.1993
(51) Int. Cl.: H03K 17/95

(54) **Mikroschalter mit einem Magnetfeld-Sensor**

(30) Priorität: 09.07.1992 DE 4222617; 10.11.1992 DE 4237928
(71) Anmelder: SIEMENS AKTIENGESELLSCHAFT, D-80333 München (DE)
(72) Erfinder: Jansseune, Luc, Ing., D-81739 München (DE)

(57) **Zusammenfassung**

Der Mikroschalter enthält zwei koaxial übereinander angeordnete Dauermagneten (1, 2), die mit ihren gleichnamigen Polen einander zugewandt sind und dabei einen Luftspalt (3) bilden, in welchem ein Magnetfeld-Sensor (4) mit Auswerteschaltung angeordnet ist. Durch Änderung der magnetischen Induktion an einem Dauermagneten (2) durch Annäherung eines ferromagnetischen Auslösekörpers (6) oder durch Verschiebung des Dauermagneten wird am Magnetfeld-Sensor (4) ein auswertbares Signal erzeugt.

## Beschreibung

Die Erfindung betrifft einen Mikroschalter mit einem Magnetfeld-Sensor und einer Schalteinrichtung, die entsprechend der magnetischen Induktion am Magnetfeld-Sensor ihren Schaltzustand ändert, sowie mit zwei Dauermagneten, wobei der Magnetfeld-Sensor im Grenzbereich der von beiden Dauermagneten erzeugten Magnetfelder angeordnet ist.

Aus der US-PS 3 226 631 ist bereits ein Magnetfeld-Schalter bekannt, bei dem zwei mit ihren Achsen parallel angeordnete Dauermagneten mit jeweils einem gleichnamigen Pol über ein Joch verbunden sind, während die beiden anderen, ebenfalls gleichnamigen Pole jeweils einen Polschuh tragen, wobei die freien Enden der Polschuhe einen Spalt bilden, in welchem ein Magnetfeld-Sensor angeordnet ist. Wird über den Spalt ein ferromagnetischer Auslösekörper, beispielsweise eine Eisenschiene, bewegt, wird dies über den Magnetfeld -Sensor erfaßt und ausgewertet. Allerdings ist der dortige Aufbau für einen Mikroschalter zu aufwendig und zu groß.

Aufgabe der vorliegenden Erfindung ist es, einen Mikroschalter der eingangs genannten Art zu schaffen, der mit möglichst wenigen und möglichst kleinen Bauteilen einfach aufgebaut ist und eine sichere Betätigung ermöglicht, ohne gegen unerwünschte Fremdeinflüsse empfindlich zu sein.

Erfindungsgemäß wird diese Aufgabe mit einem Mikroschalter gelöst, bei dem die beiden säulenförmigen Dauermagneten koaxial zueinander und mit jeweils gleichnamigen Polen einander zugewandt unter Bildung eines Luftspaltes angeordnet sind, wobei in dem Luftspalt der Magnetfeld-Sensor fest angeordnet ist.

Die Aufgabe wird auch durch einen Mikroschalter gelöst, bei dem die beiden säulenförmigen Dauermagneten koaxial zueinander und mit jeweils ungleichnamigen Polen einander zugewandt unter Bildung eines Luftspaltes angeordnet sind, wobei in dem Luftspalt der plättchenförmige Magnetfeld-Sensor in Axialrichtung fest angeordnet ist.

Bei dem erfindungsgemäßen Schalter sind also die beiden Dauermagneten unmittelbar übereinander so angeordnet, daß sie selbst den Luftspalt für den Magnetfeld-Sensor bilden, so daß zusätzliche Joche oder Polschuhe nicht erforderlich werden. Für die Anordnung können kleine, beispielsweise runde Magneten verwendet werden, so daß sich insgesamt ein Schalter mit sehr kleinem Volumen bilden läßt.

In einer Ausgestaltung des Schalters sind die beiden Dauermagneten in einem festen Abstand zueinander angeordnet, wobei der Magnetfeld-Sensor in dem Luftspalt ebenfalls in fester Beziehung zu beiden Dauermagneten derart fixiert ist, daß die magnetische Induktion am Magnetfeld-Sensor im Ruhezustand auf einen festen Wert eingestellt ist und bei Annäherung eines ferromagnetischen Auslösekörpers an einen vom Magnetfeld-Sensor abgewandten Pol eines der Dauermagneten, oder an eine der zur Axialrichtung parallelen Seiten der Dauermagneten, eine gegenüber dem Ruhezustand veränderte, über die Schalteinrichtung auswertbare Größe annimmt.

Die Anordnung des Magnetfeld-Sensors ist somit getrennt von dem Schaltbereich für den Auslösekörper an einem der außenliegenden Dauermagnetpole. Auch hierdurch wird ein besonders einfacher Aufbau des Schalters ermöglicht.

In einer anderen vorteilhaften Ausführungsform ist es auch möglich, daß ein erster der beiden Dauermagneten zusammen mit dem Magnetfeld-Sensor in fester Zuordnung fixiert ist und daß der zweite Dauermagnet in Axialrichtung verschiebbar geführt und durch eine Rückstellkraft in eine von dem Magnetfeld-Sensor entfernte Ruhestellung vorgespannt ist, wobei in der Ruhestellung eine am Magnetfeld-Sensor wirksame magnetische Induktion auswertbar ist und bei Verschiebung des zweiten Dauermagneten entgegen der Rückstellkraft in eine Arbeitsstellung am Magnetfeld-Sensor die gemessene Induktion um einen auswertbaren Betrag verringert wird. Dabei erhält man eine besonders einfache Konstruktion, wenn die magnetische Abstoßung zwischen beiden Dauermagneten als Rückstellkraft verwendet wird. Der zweite Dauermagnet kann dabei mit einem im Gehäuse axial geführten Betätigungsstößel aus nicht-ferromagnetischem Material verbunden sein.

Als Magnetfeld-Sensor kann je nach den Anwendungsbedingungen ein Magnetfeld-Sensor oder ein Magnetoresistor (eine Feldplatte) Verwendung finden. Auch andere magnetfeldempfindliche Elemente, wie Magnetfelddioden und dergleichen sind denkbar.

Die Erfindung wird nachfolgend an Ausführungsbeispielen anhand der Zeichnung näher erläutert. Es zeigen
Figur 1 den grundsätzlichen Aufbau einer erfindungsgemäßen Ausführungsform eines Mikroschalters mit zwei Dauermagneten, einem Magnetfeld-Schaltkreis und einem Auslösekörper,
Figur 2 eine Kurve zur Darstellung eines beispielhaften Verlaufs der magnetischen Induktion am Magnetfeld-Sensor in Abhängigkeit vom Abstand eines Auslösekörpers gemäß Figur 1,
Figur 3 den konstruktiven Aufbau eines Mikroschalters mit einem Magnetfeld-Sensor in einem Gehäuse,
Figur 4 ein Funktionsschaltbild eines integrierten Schaltkreises mit Magnetfeld-Sensor und Auswerteschaltung,
Figur 5 eine weitere Ausführungsform eines Mikroschalters mit einem Magnetfeld-Sensor und einem beweglichen Dauermagneten,
Figur 6 eine Kurve für einen beispielhaften Verlauf der magnetischen Induktion am Magnetfeld-Sensor in einer Anordnung gemäß Figur 5.
Figur 7 bis 12 den grundsätzlichen Aufbau weiterer Ausführungsformen eines erfindungsgemäßen Mikroschalters.

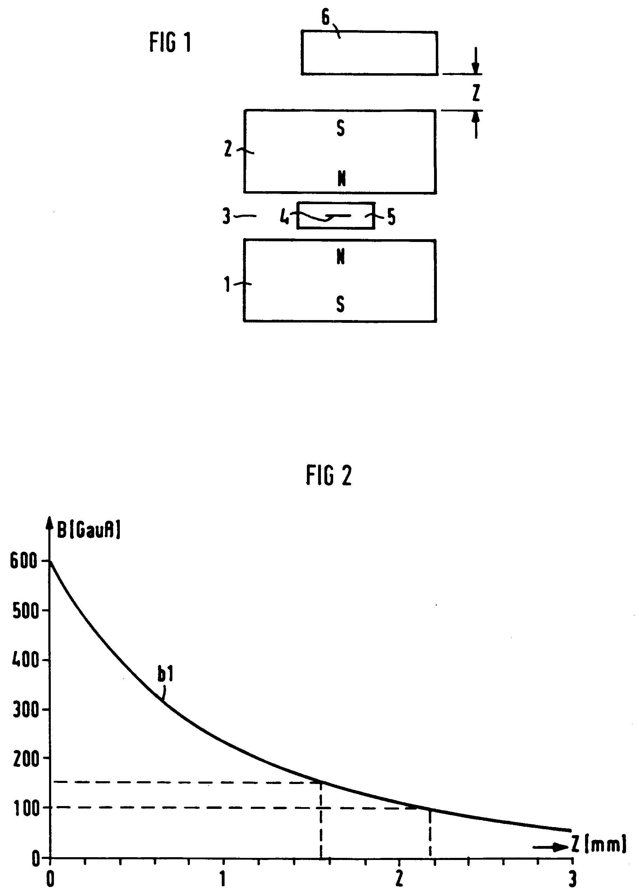

Figur 1 zeigt schematisch die Anordnung eines Mikroschalters mit Magnetfeld-Effekt. Dabei sind zwei Dauermagneten 1 und 2, die beispielsweise zylinderförmig oder auch quaderförmig sein können, koaxial mit entgegengesetzten Polarisierungsrichtungen übereinander angeordnet, so daß gleichnamige Pole, im Beispiel die Nordpole N, einander zugewandt sind. Zwischen den beiden Dauermagneten 1 und 2 ist ein Luftspalt 3 gebildet, in welchem ein Magnetfeld-Sensor 4 als Teil eines eine Auswerteschaltung enthaltenden Magnetfeld-Chips 5 angeordnet ist. Der Magnetfeld-Sensor 4 befindet sich dabei genau oder zumindest annähernd in der neutralen Zone zwischen den beiden Dauermagneten. Die Flüsse von den gleichnamigen Polen der beiden Magneten stoßen einander ab, so daß der Magnetfeld-Sensor keine magnetische Induktion erfährt.

Wird jedoch ein ferromagnetischer Auslösekörper 6 an einen der außenliegenden Pole, im Beispiel an einen der Südpole S, angenähert, so wird das Gleichgewicht der Magnetfelder gestört; am Magnetfeld-Sensor tritt eine meßbare magnetische Induktion auf. Diese wird zum Umschalten einer im Magnetfeld-Chip 5 enthaltenen Auswerteschaltung genutzt.

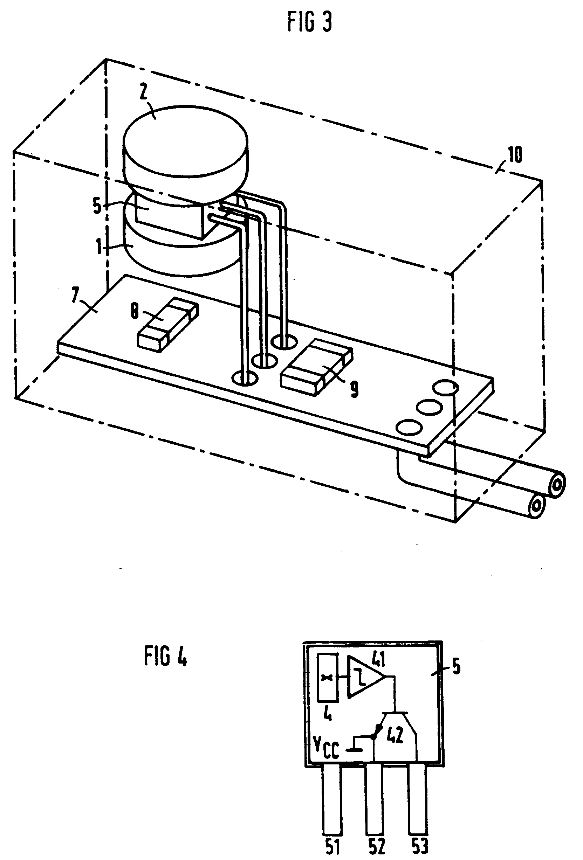

Eine integrierte Schaltung in Form eines Magnetfeld-Chips 5 mit einem Magnetfeld-Sensor 4, einer Schwellenwertschaltung (einem Schmitt-Trigger) 41 und einem Halbleiterschalter 42 ist beispielshalber in Figur 4 gezeigt. Derartige Magnetfeld-Sensor sind handelsüblich. Der dargestellte Chip 5 besitzt in der Regel drei Anschlußfahnen, nämlich einen Versorgungsanschluß 51, einen Masseanschluß 52 und einen Signalausgangsanschluß 53.

Figur 2 zeigt, lediglich beispielhaft, den Verlauf b1 der magnetischen Induktion am Magn-Sensor 4 in Figur 1 in Abhängigkeit vom Abstand z des Auslösekörpers 6 vom Dauermagneten 2. Daraus ist ersichtlich, daß bei Verringerung des Abstandes z die magnetische Induktion B ansteigt. Bei dem gezeigten Beispiel liegt die schaltschwelle des Hall-IC's 5 bei 150 G, entsprechend einem Abstand z von annähernd 1,5 mm. Die Ausschaltschwelle liegt dagegen aufgrund der Hysterese im Schwellenwertschalter 41 bei etwa 100 G, entsprechend einem Abstand z von etwa 2,2 mm. Dies sind lediglich Zahlenangaben eines ganz bestimmten Ausführungsbeispiels; je nach den Kennwerten des verwendeten Hall-IC's und der übrigen Teile variieren natürlich auch diese Schwellenwerte.

In Figur 3 ist ein möglicher konstruktiver Aufbau für einen erfindungsgemäßen Schalter gezeigt. Dabei ist eine Leiterplatte 7 vorgesehen, welche den Hall-IC 5 trägt. Auf der Leiterplatte sind weitere Bauelemente, beispielsweise ein Widerstand 8 und ein Kondensator 9, andeutungsweise gezeigt. Diese dienen beispielsweise zur Sicherung des Hall-IC's 5 gegen Überspannungen. Die Leiterplatte mit ihren Bauteilen ist in einem in den Umrissen angedeuteten Gehäuse 10 untergebracht, wobei die Innengestaltung des Gehäuses mit entsprechenden Abstützungen und Führungen nicht gezeigt ist. Die beiden Dauermagneten 1 und 2 sind ebenfalls in dem Gehäuse in entsprechenden, nicht dargestellten Führungen angeordnet, wobei sie vorzugsweise mit Preßsitz in einem Führungskanal so angeordnet sind, daß sie zur Justierung verschoben werden können. Nach der Justierung kann die Leiterplatte mit den Dauermagneten beispielsweise im Gehäuse fest verschlossen, vorzugsweise vergossen werden.

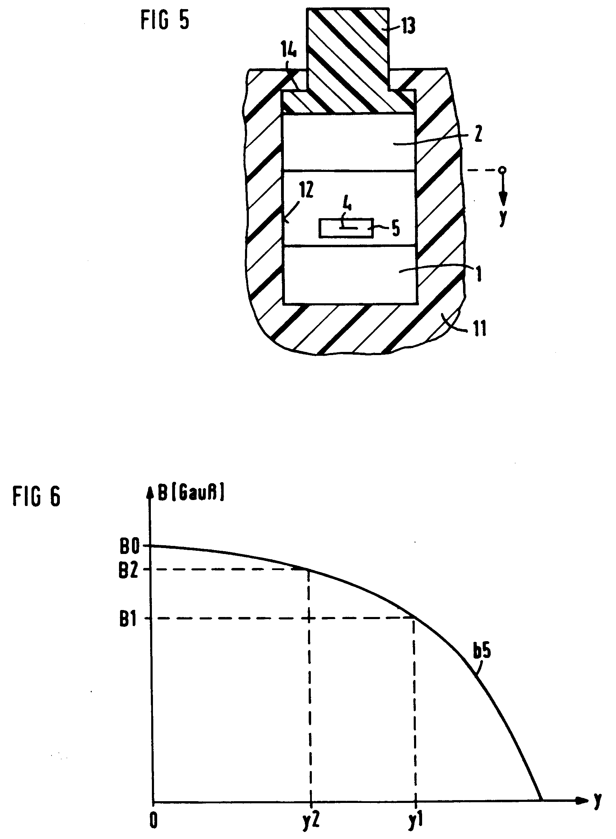

Figur 5 zeigt eine weitere Ausführungsform für einen erfindungsgemäßen Mikroschalter. In diesem Fall ist der Dauermagnet 1 mit dem darüberliegenden Hall-IC 5 fest in einem Gehäuse 11 angeordnet, während der zweite Dauermagnet 2 in einer Gehäuseführung 12 axial verschiebbar angeordnet ist. Der Dauermagnet 2 ist mit einem Schaltstößel 13 aus nicht ferromagnetischem Material versehen, der von außen betätigbar ist. Da die beiden Nordpole N der Dauermagneten 1 und 2 einander zugewandt sind, stoßen sich die beiden Magnete ab, so daß der Dauermagnet 2 mit dem Schaltstößel 13 im Ruhezustand an einem oberen Gehäuseanschlag 14 liegt. Wird der Schaltstößel zur Betätigung nach unten bewegt, verändert sich die magnetische Induktion an dem Magnetfeld-Sensor 4, was wiederum als Schaltsignal auswertbar ist.

Figur 6 zeigt den Verlauf der magnetischen Induktion an einer beispielhaften Kurve b5 in Abhängigkeit vom Weg des Schaltstößels in Richtung y. Da der Dauermagnet 2 im Ruhezustand weiter vom Magnetfeld-Sensor 4 entfernt ist als der Dauermagnet 1, wird im Ruhezustand, d. h. bei y = 0, eine magnetische Induktion B0 gemessen. Während der Bewegung des Schaltstößels 13 und des Dauermagneten 2 nach unten verringert sich diese magnetische Induktion entsprechend der Kurve b5, bis die Einschaltschwelle B1 an dem Punkt y1 erreicht ist. Wird der Schaltstößel losgelassen, so daß der Dauermagnet 2 aufgrund der magnetischen Abstoßung sich wieder nach oben bewegt, erreicht er die Ausschaltschwelle mit dem Induktionswert B2 an der Wegstelle y2. Auch in diesem Fall wird also durch die Hysterese sichergestellt, daß der Einschaltpunkt und der Ausschaltpunkt in einem gewissen Abstand voneinander liegen, um jeweils einen eindeutig definierten Schaltzustand zu gewährleisten.

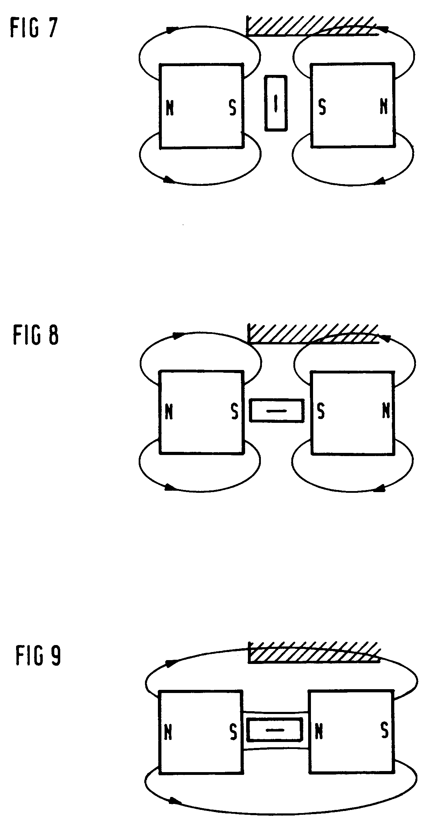

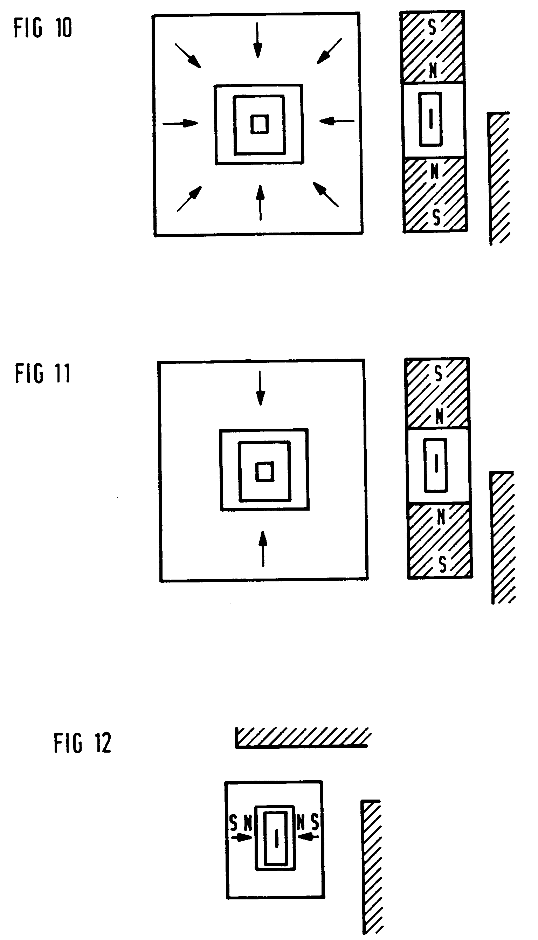

Figur 7 zeigt schematisch eine weitere mögliche Anordnung eines Mikroschalters mit Hall-Effekt. Im Unterschied zur Figur 1 wird der Auslösekörper 6 nicht an einen der außenliegenden Pole, sondern an eine zur Axialrichtung parallele Seite eines der beiden Dauermagneten angenähert. Die aktive Flache, über die das Gleichgewicht der Magnetfelder gestört wird, befindet sich in diesem Fall, ebenso wie bei den Ausfürungsbeispielen gemäß Figur 8 und 9, nicht an der Polfläche, sondern seitlich am Magneten. In FIG 8 ist der plättchenförmige Magnetfeld-Sensor 4 in Axialrichtung zwischen gleichnamigen Polen der beiden Dauermagneten angeordnet. Bei dieser Ausrichtung des Sensors wird dieser oben und unten symmetrisch von Flußlinien durchflossen. Durch Annäherung des Auslöseteils 6 an eine Seite eines der Magneten wird dieses Gleichgewicht gestört.

Figur 9 zeigt eine alternative Anordnung, bei der der Sensor in Axialrichtung zwischen ungleichnamigen Polen angeordnet ist und der Auslösekörper 6 seitlich angenähert wird. Bei dieser Ausrichtung befindet sich der Sensor nicht in der Front zwischen zwei gegeneinander gerichteten Magnetfeldern, sondern er ist tangential zu den Magnetflußlinien ausgerichtet. Durch asymmetrische Änderung durch das umliegende Medium mittels des Auslösekörpers 6 verziehen sich, analog wie bei den anderen Ausführungsbeispielen, die Feldlinien und laufen nicht mehr mit dem Sensor parallel. Nur die dabei entstehende, senkrecht auf dem Sensor stehende Magnetflußkomponente wird vom Sensor wahrgenommen und ausgewertet.

Die Erfindung ist nicht darauf beschränkt, daß der Fluß durch den Sensor im Ruhezustand gleich oder nahe Null ist. Die Anordnung kann beispielsweise auch derart gewählt sein, daß im Ruhezustand ein Fluß von 80 G durch den Sensor fließt, der sich bei Betätigung erhöht, bis die Schaltschwelle von beispielsweise 100 G überschritten wird. Umgekehrt kann von der Anwendung her auch eine Anordung vorteilhaft sein, bei der der Fluß zunächst über der Schaltschwelle liegt und durch die Annäherung des Auslösekörpers unter die Schaltschwelle gezogen wird.

Weitere Ausführungsformen sind in den Figuren 10 bis 12 dargestellt. Die Anordnung gemäß Figur 10 funktioniert analog der Anordnung in Figur 8, wobei in Figur 10 jedoch ein radial aufmagnetisierter Magnet verwendet ist. Figur 11 zeigt eine Anordnung wie Figur 10, jedoch mit vereinfachter Aufmagnetisierung. Figur 12 zeigt eine Anordnung nach dem gleichen Prinzip wie in den Figuren 10 und 11, jedoch mit nur einem, in zwei gegenübergestellten Richtungen aufmagnetisierten Magneten.

Die in den Ausführungsbeispielen verwendeten IC's können nicht nur einen, sondern auch zwei aktive Bereiche haben (unipolares IC mit 2 Ausgängen), oder als Latch funktionieren (bipolares IC).

Die Anschlußfahnen des Magnetfeld-IC können auf verschiedene Weise, beispielsweise wie in FIG 3 dargestellt, durch das Gehäuse nach außen geführt und mit Anschlüssen des Schalters insgesamt verbunden sein. Diese Anschlüsse können jede beliebige Form haben, insbesondere können sie als an einer Leiterplatte oder Leiterstreifen angeordnete Schneidklemmanschlüsse (Crimpanschlüsse) ausgebildet sein, wie sie in der DE-PS 42 11 486 näher beschrieben sind.

## Patentansprüche

1. Mikroschalter mit einem Magnetfeld-Sensor (4) und einer Schalteinrichtung (41, 42), die entsprechend der magnetischen Induktion am Magnetfeld-Sensor ihren Schaltzustand ändert, sowie mit zwei Dauermagneten (1, 2), wobei der Magnetfeld-Sensor (4) im Grenzbereich der von beiden Dauermagneten erzeugten Magnetfelder angeordnet ist, **dadurch gekennzeichnet,** daß die beiden säulenförmigen Dauermagneten (1, 2) koaxial zueinander und mit jeweils gleichnamigen Polen einander zugewandt unter Bildung eines Luftspaltes (3) angeordnet sind und daß in dem Luftspalt (3) der Magnetfeld-Sensor (4) fest angeordnet ist.

2. Mikroschalter mit einem Magnetfeld-Sensor (4) und einer Schalteinrichtung (41, 42), die entsprechend der magnetischen Induktion am Magnetfeld-Sensor ihren Schaltzustand ändert, sowie mit zwei Dauermagneten (1, 2), wobei der Magnetfeld-Sensor (4) im Grenzbereich der von beiden Dauermagneten erzeugten Magnetfelder angeordnet ist, **dadurch gekennzeichnet,** daß die beiden säulenförmigen Dauermagneten (1, 2) koaxial zueinander und mit jeweils ungleichnamigen Polen einander zugewandt unter Bildung eines Luftspaltes (3) angeordnet sind und daß in dem Luftspalt (3) der plättchenförmige Magnetfeld-Sensor (4) in Axialrichtung fest angeordnet ist.

3. Mikroschalter nach Anspruch 1,
**dadurch gekennzeichnet,** daß die beiden Dauermagneten (1, 2) in einem festen Abstand zueinander angeordnet sind und daß der Magnetfeld-Sensor (4) in dem Luftspalt (3) ebenfalls in fester Beziehung zu beiden Dauermagneten derart fixiert ist, daß die magnetische Induktion am Magnetfeld-Sensor im Ruhezustand auf einen festen Wert eingestellt ist und bei Annäherung eines ferromagnetischen Auslösekörpers (6) an einen vom Magnetfeld-Sensor abgewandten Pol (S) eines der Dauermagneten (2) eine gegenüber dem Ruhezustand veränderte, über die Schalteinrichtung (41, 42) auswertbare Größe annimmt.

4. Mikroschalter nach Anspruch 1 oder 2,
**dadurch gekennzeichnet,** daß die beiden Dauermagneten (1, 2) in einem festen Abstand zueinander angeordnet sind und daß der Magnetfeld-Sensor (4) in dem Luftspalt (3) ebenfalls in fester Beziehung zu beiden Dauermagneten derart fixiert ist, daß die magnetische Induktion am Magnetfeld-Sensor im Ruhezustand auf einen festen Wert eingestellt ist und bei Annäherung eines ferromagnetischen Auslösekörpers (6) an eine zur Axialrichtung parallele Seite eines der Dauermagneten (2) eine gegenüber dem Ruhezustand veränderte, über die Schalteinrichtung (41, 42) auswertbare Größe annimmt.

5. Mikroschalter nach Anspruch 1,
**dadurch gekennzeichnet,** daß ein erster der beiden Dauermagneten (1) zusammen mit dem Magnetfeld-Sensor (4) in fester Zuordnung fixiert ist und daß der zweite Dauermagnet (2) in Axialrichtung verschiebbar geführt und durch eine Rückstellkraft in eine von dem Magnetfeld-Sensor entfernte Ruhestellung (14) vorgespannt ist, wobei in der Ruhestellung eine am Magnetfeld-Sensor wirksame magnetische Induktion auswertbar ist und bei Verschiebung des zweiten Dauermagneten (2) entgegen der Rückstellkraft in eine Arbeitsstellung am Magnetfeld-Sensor die gemessene Induktion um einen auswertbaren Betrag verringert wird.

6. Mikroschalter nach Anspruch 5,
**dadurch gekennzeichnet,** daß die magnetische Abstoßung zwischen beiden Dauermagneten (1, 2) als Rückstellkraft verwendet wird.

7. Mikroschalter nach Anspruch 5 oder 6,
**dadurch gekennzeichnet,** daß der zweite Dauermagnet (2) mit einem in einem Gehäuse (11) geführten Betätigungsstößel (13) aus nicht ferromagnetischem Material verbunden ist.

8. Mikroschalter nach einem der Ansprüche 1 bis 7,
**dadurch gekennzeichnet,**
daß als Magnetfeld-Sensor jeweils ein Hall-Sensor verwendet ist.

9. Mikroschalter nach einem der Ansprüche 1 bis 7,
**dadurch gekennzeichnet,**
daß als Magnetfeld-Sensor ein Magnetoresistor verwendet ist.

10. Mikroschalter nach einem der Ansprüche 1 bis 9,
**dadurch gekennzeichnet,**
daß die Anschlüsse des Schalters insgesamt als Schneidklemmanschlüsse ausgebildet sind.
